Europäisches Patentamt

European Patent Office

Office européen des brevets

(11) Veröffentlichungsnummer: **0 490 071 A1**

# EUROPÄISCHE PATENTANMELDUNG

(21) Anmeldenummer: **91118216.0**

(22) Anmeldetag: **25.10.91**

(51) Int. Cl.5: **C30B 13/24**, C30B 30/08

(30) Priorität: **12.12.90 DE 4039546**

(43) Veröffentlichungstag der Anmeldung:
**17.06.92 Patentblatt 92/25**

(84) Benannte Vertragsstaaten:
**AT BE DE FR IT NL SE**

(71) Anmelder: **Battelle-Institut e.V.
Am Römerhof 35 Postfach 900 160
W-6000 Frankfurt/Main 90(DE)**

(72) Erfinder: **Bergmeister, Franz-Josef, Dr.
Schweizerstrasse 44
W-6000 Frankfurt am Main 70(DE)**
Erfinder: **Harr, Michael, Dr.
Liederbacher Strasse 78
W-6230 Frankfurt am Main 80(DE)**

(54) **Vorrichtung zur Herstellung von fehlerarmen Kristallen im Zonenschmelzverfahren.**

(57) Vorrichtung zur Herstellung von fehlerarmen Kristallen im Zonenschmelzverfahren mit einem rotationssymmetrischen Spiegelofen (1) mit einer Lichtquelle (4) in einem Brennpunktbereich des Ofens, mit Bewegungseinrichtungen (3), die eine Probe (2) aus einem zweiten Brennpunktbereich (2b) im Raum zwischen den Brennpunkten in Richtung auf die Lichtquelle bewegen und mit in diesem Raum die Probe umgebenden Nachheizern (6) und Kühleinrichtungen (7), die das Temperaturprofil der Probe unter ausschließender oder überwiegender Ausnutzung der Strahlung der Lichtquelle in diesem Raum außerhalb des zweiten Brennpunktbereichs durch lokale, aktive Kühlung und allenfalls geringfügige aktive Heizung der Nachheizer (6) formen.

Fig.1

EP 0 490 071 A1

Die Erfindung betrifft Vorrichtungen zur Herstellung von fehlerarmen Kristallen im Zonenschmelzverfahren mit Hilfe eines Spiegelofens.

Die Ausnutzung von Spiegelöfen zum sogenannten Zonenschmelzen, bei dem ein zunächst polykristalliner Stab fortlaufend bereichsweise tiegelfrei geschmolzen wird, indem er durch einen Brennpunktbereich des Spiegelofens gezogen wird, sind allgemein bekannt. Neben nicht symmetrischen Anordnungen, bei denen die Homogenität der Schmelztemperatur im Schmelzabschnitt weniger gut ist, sind auch bereits zahlreiche symmetrische Spiegelöfen, z.B. rotationssymmetrische Monoellipsoidöfen vorgeschlagen worden. Dabei wird der Rohling bzw. der neue, nach dem Aufschmelzen erstarrte Kristall durch einen der Brennpunktbereiche des rotationssymmetrischen Spiegelofens gezogen, in dessen zweitem Brennpunktbereich eine Lichtquelle, beispielsweise in Form einer Wolframlampe angeordnet ist. Es sind hierzu unterschiedliche Bewegungseinrichtungen vorgeschlagen worden, mit denen entweder die Probe aus dem Spiegelofen herausgezogen wird oder auch letzterer in Bezug auf die Probe so bewegt wird, daß der fertige Kristall aus dem Ofen austritt.

Mit derartigen Anordnungen sind Temperaturen von über 2000 °C bei geringfügiger Energieeinspeisung erzielbar, so daß sich diese Anordnungen insbesondere auch für den Einsatz im Weltraum eignen.

Ein kritischer Punkt dieser Art von Zonenschmelz-Vorrichtungen besteht darin, daß insbesondere infolge eines relativ steilen Temperaturabfalls, dem der erstarrte Kristall unterliegt, wenn er aus der Schmelzzone herausgezogen wird, die Kristallstruktur wieder fehlerhaft wird oder sogar völlig zerstört wird. Will man diesen Effekt vermeiden, so ist man gezwungen, durch aufwendige aktive Wärmequellen in Form von Nachheizern, den Temperaturabfall zu vermeiden und ein relativ hohes, konstantes Temperaturprofil im Kristall aufrechtzuerhalten. Eine solche Maßnahme widerspricht jedoch dem mit der Spiegelanordnung angestrebten Prinzip eines möglichst geringen Energieverbrauchs bei effektiver Erwärmung.

Der Erfindung liegt daher die Aufgabe zugrunde, eine verbesserte Vorrichtung der oben genannten Art anzugeben, die es gestattet, mit einfachen technischen Mitteln und geringem Energieverbrauch fehlerarme Kristalle zu erzeugen.

Die erfindungsgemäße Lösung gemäß dem Hauptanspruch beinhaltet Bewegungseinrichtungen, die im Gegensatz zum Stand der Technik eine solche Relativbewegung zwischen Probe und Spiegelofen hervorrufen, daß die Probe im Schmelzverfahren nicht mehr aus dem Ofen herausgezogen wird, sondern auf die Lichtquelle zubewegt wird. Es stellte sich heraus, daß durch diese einfache Maßnahme der Umkehr der Bewegungseinrichtung das von der Lichtquelle im Spiegelofen hervorgerufene Temperaturprofil speziell im Bereich oder Raum zwischen den beiden Brennpunktbereichen so ausgenutzt werden kann, daß praktisch ohne aktive Heizmaßnahmen an Nachheizern, die die Probe in diesem Bereich umgeben, ein für die Erhaltung der Kristallstruktur ideales Temperaturprofil in der erstarrten Probe erzeugbar ist. Das Niveau des Temperaturprofils ist im Anschluß an die Schmelzzone auf der der Spiegelofeneinführungsöffnung abgewandten Seite des Brennpunkts, durch den die Probe geschoben wird, so hoch und so flach, daß eine Temperierung der Nachheizer ausreicht, die durch lokale, aktive Kühleinrichtungen im Anschluß an den Schmelzbereich aufbringbar ist. Soll der Effekt der Temperaturprofilformung durch aktive Heizmaßnahmen noch weiter verbessert werden, so reichen sehr geringe Energiezufuhren aus.

Somit kann allein durch Ausnutzen der bereits vorliegenden Energie der Lichtquelle dafür gesorgt werden, daß das Temperaturprofil so geformt oder angepaßt wird, daß weitgehend fehlerfreie Kristalle züchtbar sind.

Vorzugsweise sind die Halterungen für die Nachheiz- und Kühleinrichtungen so ausgelegt, daß sich keine störenden strukturellen Abschattungseffekte ergeben, die den Schmelzvorgang in nachteiliger Weise beeinflussen könnten. Dies wird insbesondere dadurch erzielt, daß diese Halterungen durch einen bezüglich der Spiegelofenachse nicht parallelen und radialen Verlauf lediglich insgesamt eine geringfügige diffuse Schwächung des Lichts hervorrufen. Auf diese Weise, ist es möglich, die Halterungen so auszulegen, daß sie neben Signalleitungen von Temperaturfühlern und gegebenenfalls Heizleitungen auch Kühlmittelleitungen aufnehmen können und so die Maßnahmen zur Temperaturprofilformung erleichtern.

Im folgenden wird die Erfindung anhand der Zeichnungen näher erläutert.

Es zeigen:

Fig. 1    ein Ausführungsbeispiel der erfindungsgemäßen Vorrichtung,

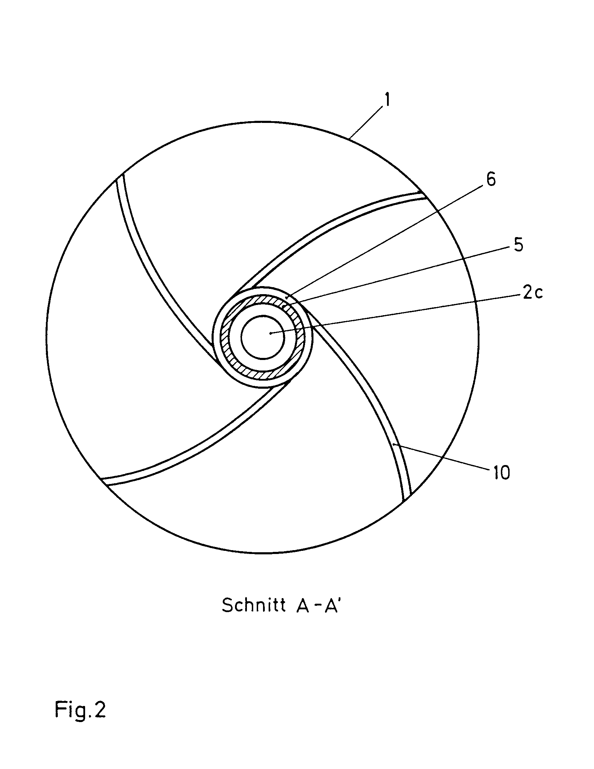

Fig. 2    einen Schnitt durch die Vorrichtung aus Fig.1 entlang AA' und

Fig. 3    ein in der erfindungsgemäßen Vorrichtung hervorgerufenes Temperaturprofil.

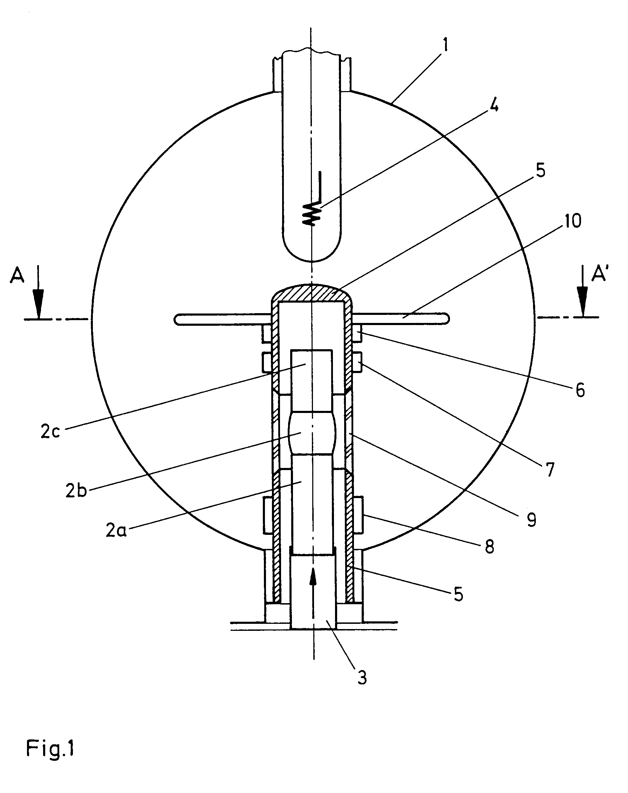

Die in Fig.1 skizzierte Vorrichtung umfaßt einen Spiegelofen 1 in Form eines rotationssymmetrischen Ellipsoids. Es sind jedoch auch andere rotationssymmetrische Spiegelanordnungen mit mindestens zwei Brennpunkten bzw. Brennpunktbereichen möglich. Eine Probe ist durch die Bezugszahl 2 angedeutet und umfaßt im Ofen 1 einen Rohling 2a, eine Schmelzzone 2b und den Bereich des neuen Kristalls 2c. Eine Bewegungseinrichtung 3 bewegt die Probe während des Zonenschmelzens in der durch den Pfeil angezeigten Richtung auf eine Lampe 4 zu, die in einem der Brennpunktbereiche des Spiegelofens angeordnet ist. Diese Bewegung erfolgt auf der Achse des Spiegelofens 1, auf der auch der zweite Brennpunktbereich liegt, in dem die Schmelzzone 2b auftritt.

Alternativ zum Ausführungsbeispiel ist es möglich, die Bewegungseinrichtung am Spiegelofen vorzusehen und diesen in entsprechend entgegengesetzter Richtung zu bewegen, so daß die Probe wiederum der Lampe 4 angenähert wird.

Die Probe wird in einer sie umgebenden Kapsel 5 geführt, an deren hinterem, der Lampe 4 zugewandten Bereich Nachheizer 6 und Kühleinrichtungen 7 vorgesehen sind. Im vorderen Abschnitt der Kapsel 5 sind Vorheizer 8 angeordnet. Der vordere und hintere Abschnitt der Kapsel sind im Ausführungsbeispiel über eine transparente Halterung 9 verbunden. Dies ist nicht notwendig, hat jedoch den Vorteil, daß diese transparente Halterung die Spiegelflächen vor Kontaminationen schützt. Es ist stattdessen auch möglich, die Kapsel zweiteilig auszubilden und den hinteren Abschnitt mit den Nachheizern 6 und den Kühleinrichtungen 7 nur über mit 10 angezeigte spiralförmig verlaufende Halterungsstege direkt am Spiegelofen 1 zu befestigen.

Diese spiralförmige Halterung ist ein Beispiel für bezüglich der Spiegelachse nicht parallel und radial verlaufende Befestigungselemente, die insgesamt eine gewisse Schwächung des Lichts hervorrufen, jedoch keine störenden strukturellen Schattenbilder erzeugen.

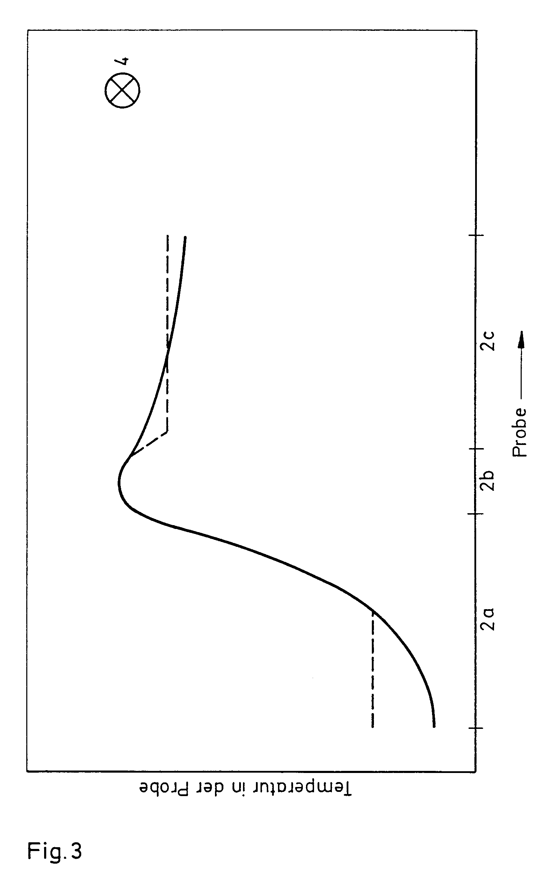

Aus der Fig.3 geht in schematischer Weise das in der Probe mit Hilfe der Lampe 4 und der Fokussierung durch die Spiegelflächen erzeugte Temperaturprofil hervor (durchgezogene Linie). Das ideale Temperaturprofil, das mit Hilfe der Vorheizer 8, Kühleinrichtungen 7 und Nachheizer 6 erzielbar ist, ist gestrichelt dargestellt. Aufgrund der durch die erfindungsgemäße Bewegungseinrichtung hervorgerufenen Bewegungsrichtung sind die Abweichungen zwischen beiden Profilen so gering, daß passive Heizmaßnahmen in Form von Temperierungen der Nachheizer 6 zum Angleichen an den gewünschten Profilverlauf ausreichen. Durch aktive Kühlung mit den Kühleinrichtungen 7 im Anschluß an die Schmelzzone 2b ist es möglich, zumindest den leichten Temperaturabfall imanschließenden Abschnitt zu kompensieren. Durch die Bewegungsrichtung erreicht mit anderen Worten der gerade erstarrte neue Kristall 2c automatisch einen durch die quasi "nicht fokussierte" Strahlung der Lampe erzeugten Temperaturbereich fast idealen Temperaturverlaufs.

Wird die Lampe 4 nicht exakt im Brennpunkt angeordnet oder werden beispielsweise mehrere Heizwendel eingesetzt, so ist es darüberhinaus auch möglich, die ebenfalls geringe Vorheizenergie durch Ausnutzen der Strahlung von der Lichtquelle im Bereich außerhalb der Schmelzzone aufzubringen, ohne daß die Lichtquelle spürbar höhere Leistungen erbringen muß. Ansonsten ist hierzu lediglich ein geringer Energieaufwand erforderlich.

Wird hingegen wie bisher die Probe 2 während des Zonenschmelzens aus dem Ofen 1 herausgezogen, so wäre der aufzubringende Energiebetrag infolge des steilen Abfalls auf der linken Seite des Temperaturprofils beträchtlich. Eine wirksame Vermeidung von Fehlern im erstarrten Kristall wäre in diesem Fall nur durch starke aktive Heizmaßnahmen möglich.

Mit Hilfe von in den Halterungen geführten, nicht dargestellten Signalleitungen von (ebenfalls nicht dargestellten) Temperaturfühlern, Kühlleitungen und gegebenenfalls Heizleitungen läßt sich das isothermische Plateau im Bereich 2c mit einer Stabilität von ± 0,1 K einstellen. In der Schmelzzone sind Temperaturen von 2000 °C mit einer Stabilität von ± 1 °C erreichbar. Die Bewegungsgeschwindigkeit der Probe liegt etwa zwischen 10 bis $10^{-3}$ mm/min. Darüberhinaus wird eine allgemein übliche Probendrehung mit etwa 1 bis 10 Umdrehungen pro Minute vorgenommen. Die Schmelzzonenlänge liegt im Bereich bis zu einigen cm. Dies gilt auch für den Schmelzzonendurchmesser und den Durchmesser der Kapsel 5. Als Atmosphäre für das Zonenschmelzen sind Vakuum oder auch z.B. Ar- oder $ArO_2$-Gasströme möglich.

Die erfindungsgemäße Vorrichtung ist insbesondere für das Zonenschmelzen im Weltraum geeignet, stellt jedoch infolge der vorteilhaften Ausnutzung des Temperaturprofils und dessen mit geringem Energieaufwand leicht erzielbaren Idealisierung allgemein eine fortschrittliche Alternative zu bestehenden Vorrichtungen dieser Art dar.

**Patentansprüche**

1. Vorrichtung zur Herstellung von fehlerarmen Kristallen im Zonenschmelzverfahren, aufweisend einen rotationssymmetrischen Spiegelofen mit einer Lichtquelle in einem Brennpunktbereich des Ofens und Bewegungseinrichtungen, die eine Relativbewegung der Probe und des Spiegelofens bewirken, bei der die Probe auf einer Spiegelofenachse durch einen zweiten Brennpunktbereich des Ofens bewegt wird,
dadurch gekennzeichnet,
daß die Bewegungseinrichtungen (3) so ausgelegt sind, daß die Probe (2) aus dem zweiten Brennpunktbereich (2b) im Raum zwischen den Brennpunkten in Richtung auf die Lichtquelle (4) bewegt wird und daß in diesem Raum die Probe (2) umgebende Nachheizer (6) und Kühleinrichtungen (7) angeordnet sind, die das Temperaturprofil der Probe (2) unter ausschließlicher oder überwiegender Ausnutzung der Strahlung der Lichtquelle (4) in diesem Raum außerhalb des zweiten Brennpunktbereichs durch lokale, aktive Kühlung und allenfalls geringfügige aktive Heizung der Nachheizer (6) formen.

2. Vorrichtung nach Anspruch 1,
dadurch gekennzeichnet,
daß die Kühleinrichtungen (7) und Nachheizer (6) mit transparenten Halterungen (10) am Spiegelofen (1) befestigt sind.

3. Vorrichtung nach Anspruch 1 oder 2,
dadurch gekennzeichnet,
daß die Kühleinrichtungen (7) und die Nachheizer (6) mit wahlweise transparenten Halterungen (10) am Spiegelofen befestigt sind, die bezüglich der Ofenachse nicht radial und nicht parallel verlaufen.

4. Vorrichtung nach einem der vorhergehenden Ansprüche,
dadurch gekennzeichnet,
daß in den Halterungen (10) Leitungen zum Zu- und Abführen von Kühlmittel, elektrischer Energie und Meßsignalen enthalten sind.

5. Vorrichtung nach einem der vorhergehenden Ansprüche,
dadurch gekennzeichnet,
daß die Halterungen (10) von den Kühleinrichtungen (7) und Nachheizern (6) spiralförmig zum Spiegelofen (1) verlaufen.

6. Vorrichtung nach Anspruch 1,
dadurch gekennzeichnet,
daß die Kühleinrichtungen (7) und Nachheizer (6) an einem Teil der Probenkapsel (5) befestigt sind, das über ein transparentes Teil (9) am anderen Teil der zweiteiligen Probenkapsel (5) gehaltert ist.

Fig.1

Schnitt A-A'

Fig.2

Fig. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | JOURNAL OF CRYSTAL GROWTH. Bd. 49, Mai 1980, AMSTERDAM NL Seiten 71 - 76; H.TSUIKI ET AL: 'single crystal growth of pure and Nd doped Y2O3 by floating zone method with Xe arc lamp imaging furnace' * Seite 72 * --- | 1,5 | C30B13/24 C30B30/08 |
| Y | DE-C-3 541 988 (DORNIER SYSTEM GMBH) * Ansprüche 1-7; Abbildungen 1,2 * --- | 1,5 | |
| A | FR-A-2 628 192 (DORNIER GMBH) --- | | |
| A | DE-A-1 946 679 (MATSUSHITA ELECTRIC INDUSTRIAL COMPANY) --- | | |
| A | REVIEW OF SCIENTIFIC INSTRUMENTS. Bd. 60, Nr. 6, Juni 1989, NEW YORK US Seiten 1202 - 1203; S.GABRSCEK: 'an inexpensive mirror furnace' --- | | |
| A | JOURNAL OF CRYSTAL GROWTH. Bd. 57, Nr. 3, Mai 1982, AMSTERDAM NL Seiten 475 - 481; KITAMURA ET AL: 'control of interface shape by using heat reservoir in FZ growth with infrared radiation convergence type heater' --- | | |
| A | JOURNAL OF CRYSTAL GROWTH. Bd. 39, Nr. 2, August 1977, AMSTERDAM NL Seiten 211 - 215; KITAZAWA ET AL: 'a new thermal imaging system utilizing a Xe arc lamp and an ellipsoidal mirror for crystallization of refractory oxides' * Seite 211 - Seite 212; Abbildungen 1,2 * ----- | 1,5 | |

**RECHERCHIERTE SACHGEBIETE (Int. Cl.5)**

C30B

Der vorliegende Recherchenbericht wurde für alle Patentansprüche erstellt

| Recherchenort | Abschlußdatum der Recherche | Prüfer |
|---|---|---|
| DEN HAAG | 25 MAERZ 1992 | COOK S.D. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument